# EUROPÄISCHE PATENTSCHRIFT

(11) **EP 2 372 749 B1**
(45) Veröffentlichungstag und Bekanntmachung des Hinweises auf die Patenterteilung: **29.09.2021**
(21) Anmeldenummer: 11156847.3
(22) Anmeldetag: 03.03.2011
(51) Int. Cl.: H01L 21/67, H01L 21/687

(54) **Behandlungsvorrichtung zur Behandlung einer Oberfläche eines Körpers**
Treatment device for treating a surface of a body
Dispositif de traitement pour le traitement d'une surface d'un corps

(30) Priorität: 31.03.2010 EP 10158604
(43) Veröffentlichungstag der Anmeldung: 05.10.2011
(73) Patentinhaber: Levitronix GmbH, 8005 Zürich (CH)
(72) Erfinder: Schöb, Dr., Reto, 8964, Rudolfstetten (CH)
(74) Vertreter: IPS Irsch AG

(56) Entgegenhaltungen:
- EP-A1- 1 288 511
- EP-A2- 0 989 594
- WO-A1-97/03225
- WO-A1-2012/028181
- JP-A- 2000 183 010
- US-A1- 2004 050 491
- US-A1- 2009 084 409

## Beschreibung

Die Erfindung betrifft eine Behandlungsvorrichtung zur Behandlung einer Oberfläche eines Körpers, insbesondere zur Behandlung eines Wafers gemäss dem Oberbegriff des unabhängigen Anspruchs 1.

In vielen industriellen Prozessen, beispielsweise in der Halbleiter- und Chip-Herstellung besteht die Notwendigkeit, bestimmte Oberflächen von Substraten, zum Beispiel die Oberfläche von Wafern für die Herstellung elektronischer Bauteile mit Suspensionen in kontrollierter Weise zu beaufschlagen um deren Oberflächen zu bearbeiten. Als ein wichtiges Beispiel seien hier chemisch-mechanische Polierprozesse (CMP, chemicalmechanical planerisation, Reinigen und / oder Ätzen von Wafern oder das entfernen von Fotolack mit Lösungsmitteln, auch Polymer Removal genannt) genannt, wie sie z.B. in der Halbleiterindustrie eingesetzt werden. Bei solchen Prozessen wird eine üblicherweise als Slurry bezeichnete Suspension aus typischerweise sehr feinen Feststoffpartikeln und einer Flüssigkeit auf einen rotierenden Wafer aufgebracht und dient dort zum Polieren bzw. Läppen der sehr feinen Halbleiterstrukturen. Ein anderes Beispiel ist das Aufbringen von Fotolack auf den Wafer, oder das Aufrauen von Oberflächen von Computerfestplatten, um ein Anhaften der Schreib/Leseköpfe durch Adhäsionskräfte, also zum Beispiel durch Van-der-Waals Kräfte zu verhindern.

Sehr häufig müssen die Oberflächen in mehreren aufeinanderfolgenden Arbeitschritten mit unterschiedlichen Flüssigkeiten bearbeitet werden. Im Falle von Wafern für die Halbleiterherstellung werden diese zum Beispiel in Form von dünnen Scheiben in einer Prozesskammer auf einer rotierbaren Halterung montiert, die über eine Drehachse von einem Elektromotor angetrieben wird, der sich ausserhalb der Prozesskammer befindet. Der dünne Wafer wird so in eine schnelle Rotation versetzt und dessen Oberfläche nacheinander mit verschiedenen, in der Regel flüssigen Behandlungsmedien beaufschlagt.

Allen diesen Arbeitsschritten ist gemeinsam, dass aus einer geeigneten Zuführeinrichtung, zum Beispiel aus einer Düse eine gewisse Menge des entsprechenden Behandlungsmediums auf den rotieren Wafer aufgebracht wird. Unter der schnellen Rotation wird die Flüssigkeit dann vollständig, oder wie beim Beschichten des Wafers zumindest teilweise durch die Zentrifugalkraft nach aussen über den Rand des Wafers hinwegtransportiert, so dass das überschüssige Behandlungsmedium nach aussen aus der Behandlungskammer abgeführt werden kann.

Da die Behandlungsmedien in der Regel sehr teuer sind, wird versucht die verschiedenen, nacheinander angewendeten Behandlungsmedien möglichst getrennt zu sammeln, falls möglich wieder auf zu bereiten und dann zur Wiederverwendung in den Behandlungsprozess zu rezirkulieren. Dabei wird allein schon aus Umweltschutzgründen auch dann versucht die verwendeten Medien getrennt in der Behandlungskammer zu sammeln, wenn sie nicht wieder verwendet werden können.

Eine solche Vorrichtung ist zum Beispiel in der US 6,810,888 B2 beschrieben worden.

Die vorgenannte Vorrichtung gemäss US 6,810,888 B2 besteht dabei im wesentlichen aus einer drehbaren Halterung zur Halterung eines Wafers, sowie einer Düsenanordnung, die oberhalb des Wafers vorgesehen ist, mit der aus verschiedenen Düsen verschiedene Flüssigkeiten zur Bearbeitung und Behandlung der Oberfläche des Wafers auf die Oberfläche des Wafers nacheinander aufbringbar sind. Zum getrennten Sammeln der im Behandlungsablauf nacheinander auf den Wafer aufgebrachten Flüssigkeiten, ist um die Halterung für den Wafer ein System aus mehreren konzentrisch angeordneten Ringkammern vorgesehen. Jede Ringkammer verfügt dabei über eine kegelstumpfartig ausgestalteten Ablaufkegel, der zur Ringkammer hin abfallend und sich erweiternd geneigt ist, so dass, wenn der innere Rand des Ablaufkegels sich ungefähr in Höhe des rotierenden Wafers befindet, die Flüssigkeit über den äusseren Rand des Wafers auf den Ablaufkegel und über den Ablaufkegel in die vorgesehene Ringkammer gelangt. So werden in den verschiedenen konzentrischen Kammern die unterschiedlichen Flüssigkeiten nacheinander getrennt gesammelt und anschliessen über Abflussleitungen aus den verschiedenen Kammern nach aussen zur Wiederverwertung oder zur Entsorgung auch getrennt abgeleitet werden können.

Um die Flüssigkeiten den unterschiedlichen konzentrisch angeordneten Kammern nacheinander zuführen zu können, sind die Ablaufkegel der verschiedenen Ringkammern derart unterschiedlich ausgestaltet und die verschiedenen Ringkammern in vertikaler Richtung derart separat verschiebbar, dass durch eine geeignete Steuerung der vertikalen Positionen der Ringkammern, nacheinander jeder Ablaufkegel jeder Ringkammer so in Bezug auf den Wafer platzierbar ist, dass die gerade verwendete Behandlungsflüssigkeit in die vorgesehene Ringkammer abgeleitet werden kann.

Die Halterung für den Wafer, die Düsenanordnung für die Zuführung der Behandlungsflüssigkeiten, sowie das System der Ringkammern sind in einer hermetisch abgeschlossenen Prozesskammer untergebracht, damit die Behandlung der Wafer zum Beispiel auch unter einer vorgebbaren Gasatmosphäre, zum Beispiel unter einem bestimmet Prozessdruck oder unter einer Schutzgasatmosphäre durchgeführt werden kann, zum Beispiel um Oxidationsprozesse auf der Oberfläche des Wafers zu unterdrücken. Auch werden nicht selten schädliche, z.B. ätzende oder giftige Flüssigkeiten verwendet, so dass die entsprechenden Behandlungsschritte aus Umwelt- und Sicherheitsgründen nur in einer abgeschlossenen Umgebung durchgeführt werden können.

Die Ringkammern, in denen die Flüssigkeiten gesammelt werden, sind mit flexiblen Abflussleitungen versehen, die eine vertikale Bewegung der Ringkammern erst ermöglichen und über die die gesammelte Flüssigkeit aus der Prozesskammer heraus zum Beispiel einem Recyclingsystem zugeführt werden kann. Auch der Motor zum Antrieb der Waferhalterung befindet sich aus naheliegenden Gründen ausserhalb der Prozesskammer. Dies alleine schon um eine Kontamination des Inneren der Prozesskammer durch den Motor zu verhindern, aber auch weil die Prozesskammer aus unterschiedlichen, dem Fachmann wohl bekannten Gründen möglichst klein gehalten werden soll. Die Halterung für den Wafer wird daher über eine Drehachse durch den aussen liegenden Motor in Rotation versetzt.

Somit wir durch die Vorrichtung gemäss US 6,810,888 B2 im Prinzip das Problem der getrennten Sammlung der verschiedenen verwendeten Behandlungsmedien zwar gelöst. Allerdings haben derartige Vorrichtungen einige erhebliche Nachteile.

Ein wichtiger Nachteil dieser aus dem Stand der Technik bekannten Behandlungsvorrichtungen besteht darin, dass die gesamten Ringkammern in vertikaler Richtung hin- und herbewegt werden müssen, um nacheinander die verschiedenen verwendeten Behandlungsmedien getrennt zu sammeln. Es handelt sich hier um ein kompliziertes mechanisches System konzentrischer Kammern, die zusammen mit der darin gesammelten Flüssigkeiten allein schon ein erhebliches Gewicht haben, dass von einer vertikal wirkenden Antriebsmechanik schwerfällig bewegt werden muss. Die konzentrisch ineinander liegenden Kammern müssen darüber hinaus sehr genau ineinander geführt sein, und über eine entsprechende Führungsmechanik verfügen, da es sonst möglich ist, dass sich die konzentrischen Ringkammern bei ihrer vertikalen Relativbewegung zueinander ineinander verkeilen, was selbstverständlich auch vorkommt und zum Stillstand der Anlage führt. Zur Behebung solcher Störungen muss dann die gesamte Anlage abgestellt werden, weil die Prozesskammer geöffnet werden muss. Die negativen Folgen eines solchen Stopps liegen auf der Hand. Durch die Führungsmechanik zur Realisierung einer zuverlässigen vertikalen Bewegung des gesamten Ringkammersystems, ist das Ringkammersystem mit Führungsmechanik und vertikalem Antriebsmechanismus insgesamt relativ gross, was der Forderung nach einem möglichst kleinen Prozesskammervolumen zu wider läuft.

Da die Ringkammern insgesamt in vertikaler Richtung verschiebbar sind, müssen, wie bereits erwähnt, die Abflussleitungen als flexible Leitungen ausgestaltet sein. Durch die ständige vertikale Hin- und Herbewegung der Ringkammern werden die flexiblen Abflussleitungen entsprechend mechanisch sehr stark belastet. Daher müssen die flexiblen Abflussleitungen aus teueren hochbelastbaren Materialien gefertigt sein, da ein Bersten der Abflussleitungen im Inneren der Prozesskammer unter allen Umständen verhindert werden muss. Entsprechend oft müssen gerade die Abflussleitungen kontrollierte und gewartet werden, was wiederum mit einem entsprechenden Aufwand verbunden ist.

Weitere gravierende Nachteile sind durch das Antriebssystem bedingt. Da der Antriebsmotor wie oben beschrieben ausserhalb der Prozesskammer vorgesehen werden muss, erfolgt der Antrieb der Waferhalterung über eine Antriebsachse, die in einer Durchführung im Boden der Prozesskammer dichtend gelagert werden muss. Solche Dichtungen haben grundsätzlich das Problem, dass sie immer zumindest geringe Mengen an Abrieb bzw. feinste Mengen an Schmiermittel abgeben und damit auch in die Prozesskammer abgeben. Da dies unbedingt verhindert werden muss, müssen die entsprechenden Durchführungen für die Antriebsachse nicht nur sehr gut Gasdicht sein, sondern auch entsprechend aufwändig gekapselt werden. Da sich auch bei grösstem technischem Aufwand eine Kontamination des Kammerinneren nicht vollständig verhindern lässt, wird die Prozesskammer häufig einem Überdruck eines Prozessgases ausgesetzt, so dass das Prozessgas die Kontaminationen über die Dichtungen nach aussen drückt und dadurch in die Prozesskammer nicht eindringen lässt. Das ist natürlich mit einem hohen Aufwand verbunden, allein schon um das Prozessgas unter dem benötigten Überdruck zur Verfügung zu stellen. Andererseits gibt es Prozesse, die bevorzugt unter einem Unterdruck durchgeführt werden müssen. Solche Prozesse sind dann mit einer Anlage gemäss US 6,810,888 B2 nicht durchführbar, da die Prozesskammer, wenn sie unter einem Unterdruck in Bezug auf einen ausserhalb der Prozesskammer herrschenden Druck betrieben wird, über die Durchführung der Antriebsachse von Aussen und durch Abrieb oder Schmiermittel aus der Dichtung kontaminiert würde.

Auch für Fälle, in denen der Wafer aus verfahrenstechnischen oder anderen Gründen zum Beispiel besser unter der Halterung hängend zur Bearbeitung montiert werden sollte, sind Vorrichtungen gemäss US 6,810,888 B2 grundsätzlich nicht verwendbar, da die Antriebsachse eine solche Anordnung des Wafers an der Halterung aus rein geometrischen Gründen natürlich nicht erlaubt. Der Wafer muss grundsätzlich liegend, oberhalb an der Halterung auf der der Antriebsachse gegenüber liegenden Seite in der Prozesskammer montiert werden.

Ein weiterer Nachteil besteht darin, dass die Anordnung in Bezug auf die axiale Richtung viel Raum beansprucht. Das ist vor allem dann von Nachteil, wenn die Vorrichtungen z.B. in einem Reinraum betrieben werden sollen, die aus den bekannten Gründen vorteilhaft möglichst klein gehalten werden sollen, vor allem auch weil in Reinräumen natürlich eine entsprechende Umgebungsatmosphäre aufrecht erhalten werden muss, was eine entsprechend aufwändige apparative Ausstattung mit Absauganlagen, Filtereinrichtungen, Pumpen, eventuell Einrichtungen zum Aufbau einer Schutzgasatmosphäre im Reinraum und so weiter erfordert. Um so grösser der Reinraum ist, umso aufwändiger müssen die vorgenannten Einrichtungen zum Betreiben des Reinraums ausgelegt werden und umso aufwändiger und teuerer wird entsprechend auch der Betrieb des Reinraums.

Eine andere Behandlungsvorrichtung ist aus dem Stand der Technik bekannt und zum Beispiel in der US 2004/0050491 A1 beschrieben, wobei der Stator ausserhalb der Prozesskammer angeordnet ist. Eine weitere Behandlungsvorrichtung ist in der US 2009/084409 A1 gezeigt.

Ausgehend vom Stand der Technik ist es daher eine Aufgabe der Erfindung, eine Behandlungsvorrichtung zur Behandlung einer Oberfläche eines Körpers mit mindestens zwei unterschiedlichen Behandlungsmedien vorzuschlagen, insbesondere zur Behandlung eines scheibenförmigen Wafers, die es erlaubt, die verschiedenen verwendeten Behandlungsmedien getrennt zu sammeln und im Speziellen dem Behandlungsprozess zur Wiederverwendung wieder zuzuführen. Dabei sollen die aus dem Stand der Technik bekannten Probleme mit den in vertikaler Richtung beweglichen Ringkammern vermieden werden. Die Behandlungsvorrichtung soll flexibel und einfach in der Anwendung sein und insbesondere einen einfachen und zuverlässigen, möglichst automatisierten Austausch der zu behandelnden Körper erlauben.

Durch spezielle Ausführungsbeispiele sollen durch die Erfindung auch die aus dem Stand der Technik bekannten Probleme mit den Durchführungen der Antriebsmotoren gelöst werden, so dass eine hermetische Abdichtung der Behandlungskammer einfacher und sicherer möglich ist und der zu behandelnde Körper sowohl unterhalb als auch oberhalb einer drehbaren Halterung montierbar sein. Darüber hinaus soll die Behandlungsvorrichtung besonders platzsparend ausgeführt sein, so dass diese so wenig Raum wie möglich beansprucht.

Die diese Aufgaben lösenden Gegenstände der Erfindung sind durch die Merkmale des unabhängigen Anspruchs 1 gekennzeichnet.

Die abhängigen Ansprüche beziehen sich auf besonders vorteilhafte Ausführungsformen der Erfindung.

Die Erfindung betrifft eine Behandlungsvorrichtung zur Behandlung einer Oberfläche eines Körpers mit einem ersten Behandlungsmedium und einem zweiten Behandlungsmedium. Dabei umfasst die Behandlungsvorrichtung eine um eine Drehachse rotierbare Halteeinrichtung zur Aufnahme und Halterung des Körpers, und einen mit der rotierbaren Halteeinrichtung drehfest gekoppelten Drehantrieb, sowie eine Zuführeinrichtung zur Zuführung des ersten Behandlungsmediums und des zweiten Behandlungsmediums auf die Oberfläche des in der Halteeinrichtung gehalterten Körpers. Die Behandlungsvorrichtung umfasst einen Sammelbehälter mit einem Trennelement, welches Trennelement den Sammelbehälter derart in eine erste Kammer und eine zweite Kammern unterteilt, dass das erste Behandlungsmedium in der ersten Kammer und das zweite Behandlungsmedium in der zweiten Kammer getrennt sammelbar ist. Dabei umfasst der Sammelbehälter ein in Bezug auf die Halteeinrichtung nicht verschiebbares Kammerbasisteil, und das Trennelement ist zwischen einer ersten Position und einer zweiten Position derart bewegbar angeordnet, dass in der ersten Position das erste Behandlungsmedium in die erste Kammer ableitbar ist und in der zweiten Position das zweite Behandlungsmedium in die zweite Kammer ableitbar ist.

Erfindungsgemäss ist der Drehantrieb ein lagerloser Motor, umfassend einen Stator und einen bezüglich des Stators berührungslos magnetisch gelagerten Rotor, wobei der lagerlose Motor mit Rotor und Stator innerhalb der Prozesskammer ausgebildet ist. Wesentlich für die Erfindung ist somit, dass, um eine besonders platzsparende, kompakte Bauform zu erreichen, der auch Stator innerhalb der Prozesskammer angeordnet ist.

Wesentlich ist ausserdem, dass der Sammelbehälter, der im Speziellen als Ringkammer ausgebildet ist, ein in Bezug auf die Halteeinrichtung nicht verschiebbares Kammerbasisteil besitzt. Somit ist der Sammelbehälter der vorliegenden Erfindung nicht ein aus mehreren konzentrischen Ringkammern zusammengesetzter Sammelbehälter, wie er aus dem oben beschrieben Stand der Technik bekannt ist, sondern der Sammelbehälter der vorliegenden Erfindung ist ein fest stehender, nicht verschiebbarer Sammelbehälter, der mehrere Kammern zum getrennten Sammeln der verschiedenen Behandlungsmedien umfasst. Beweglich ist hier nicht die Ringkammer insgesamt sondern lediglich das ein oder die mehreren vorhandenen Trennelemente, wobei das Trennelement zwischen einer ersten Position und einer zweiten Position derart bewegbar angeordnet ist, dass in der ersten Position das erste Behandlungsmedium in die erste Kammer ableitbar ist und in der zweiten Position das zweite Behandlungsmedium in die zweite Kammer ableitbar ist.

Dadurch sind gleich mehrere gravierende Nachteile der aus dem Stand der Technik bekannten Vorrichtungen behoben. Dadurch, dass der Sammelbehälter ein einzelner integraler Sammelbehälter ist, der nicht mehr aus einer Mehrzahl konzentrischer, gegeneinander bewegbarer Ringkammern gebildet ist, die jeweils einzeln Ringkammern in vertikaler Richtung hin- und herbewegt werden müssen, um nacheinander die verschiedenen verwendeten Behandlungsmedien getrennt sammeln zu können, kann auf jegliche komplizierte Mechanik verzichtet werden. Der erfindungsgemässe Sammelbehälter muss nicht zusammen mit der darin gesammelten Flüssigkeit bewegt werden. Stattdessen müssen nur die viel leichteren und einfacher zu führenden Trennelemente bewegt werden, die zudem nicht direkt gegeneinander geführt werden müssen wie die konzentrischen Ringräume im Stand der Technik. Dadurch sind die Anforderungen an die Präzision der vertikalen Führungsmechanik viel geringer, der Aufbau viel weniger aufwändig und damit billiger, weniger störanfällig und weniger wartungsintensiv als der komplizierte Aufbau mit vertikal beweglich konzentrischen Ringräumen.

Da der erfindungsgemässe Sammelbehälter anders als die Ringkammern im Stand der Technik nicht insgesamt in vertikaler Richtung verschiebbar sind, sondern eine feste vertikale Position haben, brauchen auch keine problematischen flexible Abflussleitungen mit den eingangs beschriebenen Problemen verwendet werden. Vielmehr können als Abflussleitungen zum Ableiten der Behandlungsmedien aus den Kammern relativ günstige und robuste, nicht flexible Leitungen, zum Beispiel Leitungen aus geeigneten Metallen oder geeigneten Kunststoffen verwendet werden.

Wie weiter unten noch detailliert beschrieben wird, entfaltet die Erfindung ihre Vorteile, wenn erfindungsgemäß anstatt eines konventionellen Antriebs, wie er im Prinzip bereits z.B. in der US 6,810,888 B2 beschrieben wird, ein lagerloser Motor verwendet wird.

In der Praxis wird das nicht verschiebbare Kammerbasisteil einen Kammerboden umfassen, durch den das erste Behandlungsmedium und das zweite Behandlungsmedium aus dem Sammelbehälter abführbar ist, bevorzugt über starre Abflussleitungen abführbar ist..

Das Trennelement kann dabei im Prinzip mit jedem geeigneten Mechanismus zwischen der ersten Position und der zweiten Position verschoben werden. In einem ersten Ausführungsbeispiel ist das Trennelement mittels einer Schubstange zwischen der ersten Position und einer zweiten Position bewegbar. Die Schubstange kann dabei in an sich bekannter Weise zum Beispiel mittels eines Linearmotors, mittels eines hydraulischen oder pneumatischen Kolbens, über ein Zahnrad oder auf jede andere geeignete Art und Weise von einem Antrieb zwischen der ersten Position und der zweiten Position bewegt werden.

In einem anderen Ausführungsbeispiel kann das Trennelement mittels einer Spindel zwischen der ersten Position und einer zweiten Position bewegbar ausgeführt sein. So kann das Trennelement zum Beispiel ein Innengewinde aufweisen, in das ein Gewindestab eingreift, so dass durch Drehen des Gewindestabes das Trennelement zwischen der ersten Position und der zweiten Position verschiebbar ist.

Bevorzugt ist am Trennelement ein dehnbarer Balg vorgesehen, so dass das Trennelement mittels des dehnbaren Balgs zwischen der ersten Position und zweiten Position bewegbar ist. Dazu kann der dehnbare Balg in an sich bekannter Weise mit einem unter Druck stehenden Fluid, zum Beispiel mit Luft oder Öl beaufschlagt werden, um eine Bewegung in eine erste Richtung zu erzeugen. Die entgegen gesetzte Bewegung kann dann zum Beispiel dadurch generiert werden, dass der Balg so ausgeführt ist, dass er unter einer elastischen Kraft in die entgegen gesetzte Richtung steht, so dass bei Druckentlastung automatisch die Bewegung in die entgegen gesetzte Richtung generiert wird.

Selbstverständlich kann das Trennelement selbst in einem vorgebbaren Bereich auch aus einer flexiblen Wand gebildet sein, bzw. einen flexiblen Abschnitt umfassen, so dass durch Dehnung oder Stauchung der flexiben Wand oder des flexiblen Abschnitts eine Bewegung zwischen der ersten Position und der zweiten Position generierbar ist.

In einem für die Praxis besonders wichtigen Ausführungsbeispiel ist die rotierbare Halteeinrichtung in einer Prozesskammer vorgesehen, die bevorzugt eine hermetisch abschliessbare Prozesskammer ist und zum Beispiel mit einem Prozessgas und / oder einem vorgebbaren Prozessdruck beaufschlagbar ist..

Erfindungsgemäß ist der Drehantrieb selbst, also der Motor zum Antrieb der Halteinrichtung innerhalb der Prozesskammer vorgesehen.

Wie bereits weiter oben bereits erwähnt, ist der Drehantrieb erfindungsgemäß ein lagerloser Motor, umfassend einen Stator und einen bezüglich des Stators berührungslos magnetisch gelagerten Rotor. Dabei bildet der Rotor des Drehantriebs vorteilhaft gleichzeitig die Halteeinrichtung. Dabei wird der Rotor in der Praxis häufig als mehr oder weniger schmaler Ring ausgebildet ist und der Rotor kann vorteilhaft permanent magnetisch sein. Dabei ist der Stator in einer nicht erfindungsgemäßen Ausführung ausserhalb der Prozesskammer vorgesehen, wodurch in der Prozesskammer zum einen wesentlich an Platz eingespart werden kann. Zum anderen liegt der rotierend antreibende Teil des Drehantriebs, nämlich der Rotor des Drehantriebs vollständig im Inneren der Prozesskammer während alle anderen Teile des Drehantriebs, insbesondere der Stator mit allen notwendigen elektrischen Anschlüssen und Ansteuerungseinrichtungen ausserhalb der Prozesskammer liegt, ohne dass eine mechanische Verbindung oder eine elektrische Leitungsverbindung zwischen dem antreibenden Rotor und dem ausserhalb der Prozesskammer liegenden Teil des Drehantriebs notwendig ist.

Da der eigentliche Drehantrieb, nämlich der Rotor des lagerlosen Motors vollständig innerhalb der Prozesskammer liegt und ausser dem vom Stator erzeugten magnetischen Antriebsfeld keinerlei physikalische Verbindung vom Rotor nach ausserhalb der Prozesskammer notwendig ist, ist auch keine Durchführung im Boden der Prozesskammer mehr notwendig, in der eine Antriebsachse dichtend gelagert werden muss. Der lagerlose Motor der als solcher an sich dem Fachmann bekannt ist, kommt nämlich völlig ohne Antriebsachse aus. Damit können die oben beschriebenen Probleme mit den Dichtungen bzw. mit Abrieb oder der Abgabe von feinsten Mengen an Schmiermittel aus dem Lager überhaupt nicht auftreten, da keine Lager mehr notwendig sind. Somit kann die Prozesskammer im Betriebszustand auf einfache Weise hermetisch geschlossen werden. Somit kann ohne grösseren technischen Aufwand eine Kontamination des Kammerinneren praktisch vollständig verhindert werden. Daher muss auch die Prozesskammer nicht mehr zwingend einem Überdruck eines Prozessgases ausgesetzt werden. Auch Prozesse, die bevorzugt unter einem Unterdruck durchgeführt werden müssen, können in einer solchen Behandlungsvorrichtung ohne Probleme durchgeführt werden, da keine undichten Durchführungen mehr vorhanden sind, durch die Gas von aussen in die Prozesskammer eindringen könnte.

Erfindungsgemäß und wenn eine besonders platzsparende, kompakte Bauform notwendig ist, ist der Stator innerhalb der Prozesskammer angeordnet. Vorteilhaft ist der Stator dann innerhalb der verschiebbaren Trennelemente angeordnet. Zum Schutz des Stators gegen die Behandlungsmedien, die z.B. physikalisch oder chemisch aggressive Stoffe wie Säuren, Laugen oder auch abrasiv wirkende Medien sein können, oder Medien, die unter einer erhöhten Temperatur stehen, ist der Stator vorteilhaft z.B. mit PTFE, Teflon, PVC, rostfreiem Stahl oder einem anderen schützenden Werkstoff vorzugsweise vollständig gekapselt. Die erfindungsgemäße Anordnung des Stators des lagerlosen Motors innerhalb der Prozesskammer hat gleich mehrere Vorteile. Einerseits kann dann der Luftspalt zwischen Rotor und Stator minimiert werden, wodurch eine effektivere elektromagnetische Kopplung zwischen Rotor und Stator erreichbar ist.

Ein weiterer wichtiger Vorteil besteht darin, dass ein solcher im Inneren der Prozesskammer angeordneter Stator in Bezug auf die axiale Richtung verhältnismässig wenig Platz beansprucht. Dass heisst, der Antriebsmotor ist ausserordentlich Flach und es können mehrere Prozesskammern bequem und sehr kompakt übereinander gestapelt werden, da der Antriebsmotor keine Komponenten hat, die in axialer Richtung über die Prozesskammer hinaus herausragen. Aber auch in radialer Richtung nimmt der Antriebsmotor über die Prozesskammer hinaus keinen zusätzlichen Raum ein, weil er vollständig mit allen Komponenten innerhalb der Prozesskammer angeordnet ist. Das ist vor allem dann von grossem Vorteil, wenn die erfindungsgemässe Behandlungsvorrichtung z.B. in einem Reinraum betrieben werden soll, die wie bereits erläutert vorteilhaft möglichst klein gehalten werden sollen. Durch Verwendung einer erfindungsgemässen Behandlungsvorrichtung mit innen liegendem Stator können ohne weiteres mehrere verschiedene Behandlungskammern gleichzeitig innerhalb eines Reinraums angeordnet werden, z.B. gestapelt werden, wobei der Raumbedarf für die Installation der Behandlungskammern innerhalb des Reinraums minimiert werden kann. Diese zuvor beschrieben Vorteile sind in vollem Umfang nur mit einem lagerlosen Motor gemäss der vorliegenden Erfindung möglich.

In der Praxis wird eine erfindungsgemässe Behandlungsvorrichtung häufig zur Behandlung einer Scheibe, insbesondere eines Wafers zur Herstellung mikroelektronischer Bauelemente verwendet werden. Für die Praxis wichtige Beispiele von Behandlungsprozessen seien hier stellvertretend für weitere mögliche Prozesse das chemisch-mechanische Polieren (CMP, chemicalmechanical planerisation), das Reinigen und / oder Ätzen von Wafern oder das Entfernen von Fotolack mit Lösungsmitteln, auch Polymer Removal genannt genannt, wie sie z.B. hauptsächlich, aber nicht nur in der Halbleiterindustrie eingesetzt werden.

Wird als Antrieb erfindungsgemäß ein lagerloser Motor verwendet, so kann der Wafer zum Beispiel alternativ auch unter der Halterung hängend zur Bearbeitung montiert werden, da keine störende Antriebsachse mehr vorhanden ist. Der Wafer muss somit nicht mehr grundsätzlich liegend, oberhalb an der Halterung auf der der Antriebsachse gegen überliegenden Seite in der Prozesskammer montiert werden.

In der industriellen Praxis wir eine Behandlungsvorrichtung der vorliegenden Erfindung zum automatischen Wechseln des Körpers einen Manipulator, insbesondere eine Programm gesteuerte Robotereinheit umfassen, wobei bevorzugt eine Vielzahl von einzelnen Behandlungskammern vorgesehen wird, wobei vorteilhaft ein einziger und nur einige wenige Manipulatoren vorgesehen sind um die Wafer automatisch und Programm gesteuert in den Behandlungsvorrichtungen zu platzieren bzw. daraus zu entfernen.

Im Folgenden wird die Erfindung an Hand der Zeichnung näher erläutert. Es zeigen in schematischer Darstellung:
- Fig. 1a: ein erstes, nicht erfindungsgemäßes Ausführungsbeispiel mit lagerlosem Motor mit Abfluss des ersten Behandlungsmediums in die erste Kammer;
- Fig. 1b: das Ausführungsbeispiel gem. Fig 1a mit Abfluss des zweiten Behandlungsmediums in die zweite Kammer;
- Fig. 2: ein zweites nicht erfindungsgemäßes Ausführungsbeispiel mit drei Kammern;
- Fig. 2a: ein weiteres nicht erfindungsgemäßes Ausführungsbeispiel gemäss Fig. 2a mit zweiseitiger Medium Beaufschlagung;
- Fig. 3a: ein mittels Linearmotor angetriebenes Trennelement;
- Fig. 3b: ein Schnitt gemäss Fig. 3a entlang der Schnittlinie A - A;
- Fig. 4: ein mittels Spindel angetriebenes Trennelement;
- Fig. 5: ein mittels Balg angetriebenes Trennelement;
- Fig. 6a - 6d: eine Bearbeitungssequenz mit liegend montiertem Wafer;
- Fig. 7a - 7d: eine Bearbeitungssequenz mit hängend montiertem Wafer.

Bevor im Folgenden auf die wesentlichen Aspekte der Erfindung anhand spezieller Ausführungsbeispiele näher eingegangen wird, soll zunächst kurz die Funktion des lagerlosen Motors erläutert werden, wie er beispielhaft und schematisch in den folgenden Figuren dargestellt ist.

Im Rahmen dieser Anmeldung ist unter einem lagerlosen Motor ein Motor zu verstehen, der einen elektromagnetischen Drehantrieb bildet und der einen magnetischen, bevorzugt permanentmagnetisch erregten Rotor und einen Stator umfasst, wobei der Rotor mittels magnetischer Kräfte berührungslos gelagert ist. Das Charakteristikum, dem der lagerlose Motor seine Bezeichnung verdankt ist, dass er keine separaten Magnetlager für den Rotor aufweist. Dazu ist der Stator als Lager- und Antriebsstator und der Rotor als passiv magnetischer Rotor, der sowohl als Lager- als auch als Antriebsrotor dient, ausgestaltet. Der Stator ist derart ausgestaltet bzw. mit elektrischen Wicklungen versehen, dass er ein elektromagnetisches Drehfeld erzeugt, welches zum einen ein Drehmoment auf den Rotor ausübt, das dessen Rotation um die Drehachse antreibt, und welches zum anderen eine beliebig einstellbare Querkraft auf den Rotor ausübt, so dass dessen radiale Position bezüglich einer zur Drehachse senkrechten Ebene vorgebbar bzw. aktiv steuerbar ist. Somit ist der Rotor im Betriebszustand mittels der elektrischen Wicklungen des Stators bezüglich dreier Freiheitsgrade, nämlich der Rotation um die Drehachse sowie der radialen Position in der zur Drehachse senkrechten Ebene (zwei Freiheitsgrade) aktiv ansteuerbar bzw. antreibbar.

Bezüglich dreier weiterer Freiheitsgrade, nämlich Verkippungen bezüglich der zur Drehachse senkrechten Ebene (zwei Freiheitsgrade) und der axialen Position ist der Rotor bei den aus dem Stand der Technik bekannten lagerlosen Motoren passiv magnetisch, das heisst nicht ansteuerbar, durch Reluktanzkräfte stabilisiert. Somit ist der Rotor im Betriebszustand durch die magnetische Wechselwirkung zwischen dem Lager/Antriebsstator und dem Rotor sowohl antreibbar als auch berührungslos lagerbar, ohne dass hierfür separate Magnetlager vorhanden sind.

In diesem Sinne ist im Rahmen dieser Anmeldung der Begriff "lagerloser Motor mit magnetischem Rotor" zu verstehen. Bezüglich weiterer Details der Ausgestaltung und der Ansteuerung bzw. Regelung des lagerlosen Motors sei hier z.B. auf die EP 0 986 162 oder auf die WO-A-96/31934 verwiesen, in welchen ein solcher lagerloser Motor am Beispiel einer Rotationspumpe offenbart ist. Insbesondere sei in diesem Zusammenhang auch auf die WO 2009/132707 A1 verwiesen, die einen lagerlosen Motor mit Ringrotor offenbart, wie er bevorzugt in der vorliegenden Erfindung verwendet werden kann.

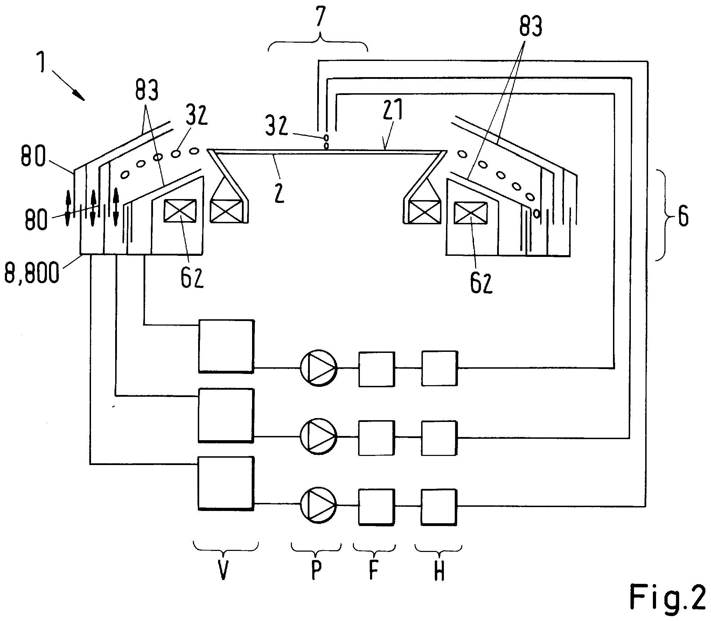

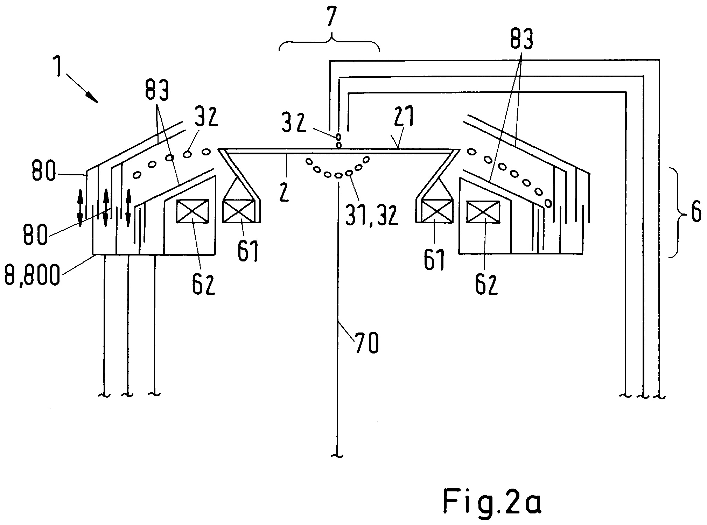

Dabei kann der Rotor unter anderem in Form einer kompakten Scheibe, oder auch als Ring, das heisst mit einer Ausnehmung in Mitte ausgebildet sein. Ein als Ring ausgebildeter Rotor wir besonders bevorzugt auch bei der vorliegenden Erfindung verwendet. Insbesondere bei grossen Rotoren hat die Ausführung des Rotors als Ring neben seinen speziellen magnetischen Eigenschaften vor allem den Vorteil, dass ein solcher ringförmiger Rotor natürlich deutlich weniger Gewicht hat, als ein scheibenförmiger Rotor mit gleichen äusseren Abmessungen, weil beim ringförmigen Rotor eine erhebliche Menge an Material durch die Ausnehmung in der Mitte des Rotors eingespart wird. Im Übrigen ist es bei Verwendung eines ringförmigen Rotors auch möglich, den vom ringförmigen Rotor getragenen Körper, im speziellen Wafer zur Herstellung mikroelektronischer Bauteile, nacheinander oder gleichzeitig von beiden Seiten mit einem Behandlungsmedium zu beaufschlagen, wie es zum Beispiel in Fig. 2a anhand eines speziellen, nicht erfindungsgemäßen Ausführungsbeispiels schematisch dargestellt ist.

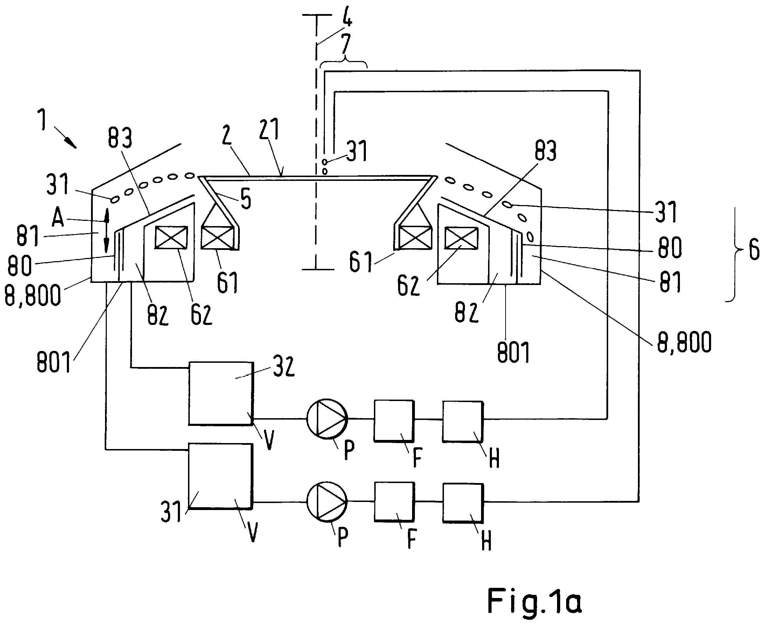

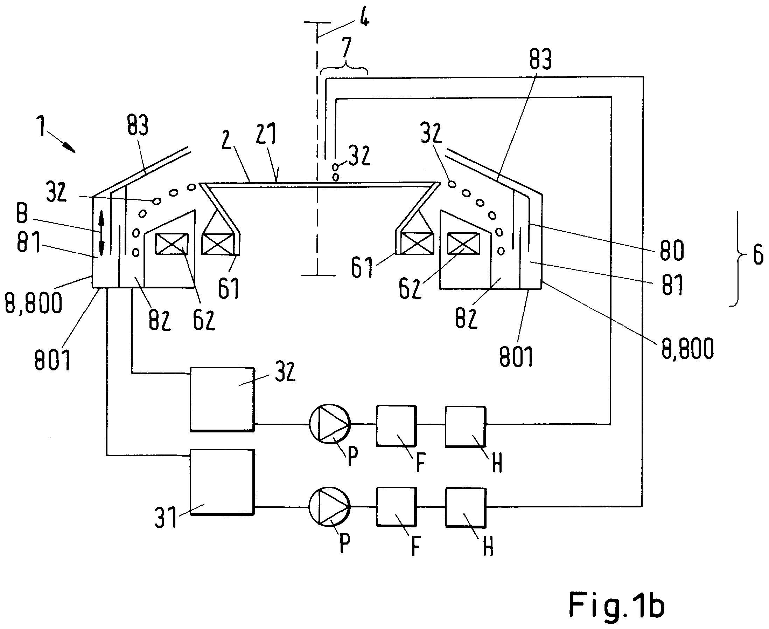

Die Fig. 1a und 1b zeigen in schematischer Darstellung ein erstes Ausführungsbeispiel einer nicht erfindungsgemässen Behandlungsvorrichtung 1 mit einem lagerlosem Motor 6. Dabei unterscheiden sich die Fig. 1a von der Fig. 1b lediglich dadurch, dass gemäss Fig. 1a das erste Behandlungsmedium 32 in einem ersten Arbeitsschritt in die erste Kammer 81 einleitet wird, während in Fig. 1b der erste Verfahrensschritt bereits abgeschlossen ist und ein zweiter Verfahrensschritt dargestellt wird, bei dem gerade ein Abfluss des zweiten Behandlungsmediums 32 in die zweite Kammer 82 dargestellt ist.

Das spezielle Ausführungsbeispiel dieser nicht erfindungsgemässen Behandlungsvorrichtung 1 zur Behandlung einer Oberfläche 21 eines Körpers 2 mit einem ersten Behandlungsmedium 31 und einem zweiten Behandlungsmedium 32 umfasst eine um eine Drehachse 4 rotierbare Halteeinrichtung 5 zur Aufnahme und Halterung des Körpers 2, der im vorliegenden Beispiel ein Wafer 2 zur Herstellung mikroelektronischer Bauteile ist. Die Behandlungsvorrichtung 1 umfasst weiter einen mit der rotierbaren Halteeinrichtung 5 drehfest gekoppelten Rotor 61 des Drehantriebs 6, sowie eine Zuführeinrichtung 7, die im nicht erfindungsgemäßen Ausführungsbeispiel der Fig. 1a und Fig. 1b in Form eines Düsenpaars 7 ausgebildet ist und das zur Zuführung des ersten Behandlungsmediums 31 und des zweiten Behandlungsmediums 32 auf die Oberfläche 21 des in der Halteeinrichtung 5 gehalterten Körpers 2 vorgesehen ist. Dabei umfasst die Behandlungsvorrichtung 1 weiter einen Sammelbehälter 8 mit einem Trennelement 80 an welchem jeweils ein Ablaufkegel 83 vorgesehen ist. Das Trennelement 80 mit Ablaufkegel 83 unterteilt den Sammelbehälter 8 derart in eine erste Kammer 81 und eine zweite Kammern 82, dass das erste Behandlungsmedium 31 in der ersten Kammer 81 und das zweite Behandlungsmedium 32 in der zweiten Kammer 82 getrennt sammelbar ist. Die Behandlungsvorrichtung 1 umfasst dabei in an sich bekannter Weise eine Prozesskammer, in der zumindest der Rotor 61 des lagerlosen Motors mit Wafer 2, die Zuführeinrichtung 7 und der Sammelbehälter 8 untergebracht sind, während der Stator 62 wie in den Figuren dargestellt bevorzugt und nicht erfindungsgemäß ausserhalb der Prozesskammer angeordnet ist. Aus Gründen der Übersichtlichkeit wurde in den Figuren auf die explizite Darstellung der Prozesskammer verzichtet.

Dabei sind die Ablaufkegel 83 an den Trennelementen 80 zwar vorteilhaft, aber nicht zwingend erforderlich. Wenn beispielweise der Wafer mit sehr hoher Drehzahl rotiert wird, ist es auch möglich, dass die vom Wafer weg geschleuderte Flüssigkeit 31, 32 grundsätzlich bis zum weitest entfernten Trennelement 80 geschleudert wird und daher automatisch in der auch ohne Ablaufkegel 83 in der richtigen Kammer 81, 82 landet, wenn nur die Höhe der Trennelemente 80 geeignet gewählt ist.

Erfindungsgemäss umfasst der Sammelbehälter 8 ein in Bezug auf die Halteeinrichtung 5 nicht verschiebbares Kammerbasisteil 800 mit einem Kammerboden 801, und das Trennelement 80 mit Ablaufkegel 83 ist zwischen einer ersten Position A und einer zweiten Position B derart bewegbar angeordnet ist, dass in der ersten Position A gemäss Fig. 1a das erste Behandlungsmedium 31 in die erste Kammer 81 ableitbar ist und in der zweiten Position B gemäss Fig. 1b das zweite Behandlungsmedium 32 in die zweite Kammer 82 ableitbar ist.

Um die Behandlungsmedien 31, 32 den beiden konzentrisch angeordneten Kammern 81, 82 nacheinander zuführen zu können, sind die Ablaufkegel 83 der verschiedenen Trennelemente 80 derart unterschiedlich ausgestaltet und die Trennelemente 80 in darstellungsgemäss vertikaler Richtung derart entlang der Drehachse 4 separat verschiebbar, dass durch eine geeignete Steuerung der vertikalen Positionen der Trennelemente 80, nacheinander jeder Ablaufkegel 83 jeder Kammer 81, 82 so in Bezug auf den Wafer platzierbar ist, dass das gerade verwendete Behandlungsmedium 31, 32 in die vorgesehene Kammer 81, 82 abgeleitet werden kann.

Damit die oft sehr teuere Behandlungsmedien 31, 32 wieder verwendet werden, sind die Kammern 81, 82 über Leitungen mit einer Recyclinganlage verbunden, die aus zwei Sammeltanks V besteht, in der das erste Behandlungsmedium 31 und das zweite Behandlungsmedium 32 getrennt gesammelt werden, von dort jeweils einer Pumpe P zugeführt werden, die die beiden Behandlungsmedien 31, 32 jeweils getrennt einem Filter F und einem Heizer H zuführt, von wo aus die so wieder aufbereiteten Behandlungsmedien 31, 32 zur erneuten Verwendung der wieder der Zuführeinrichtung 7 zugeführt werden.

Es versteht sich dabei von selbst, dass die Behandlungsvorrichtung nicht auf Vorrichtungen beschränkt ist, mit welchen lediglich zwei unterschiedliche Behandlungsmedien 31, 32 getrennt sammelbar sind. So ist anhand von Fig. 2 ein zweites nicht erfindungsgemäßes Ausführungsbeispiel gemäss Fig. 1a bzw. Fig. 1b mit drei Kammern schematisch dargestellt, mit welchem drei verschiedene Behandlungsmedien getrennt gesammelt werden können. Der Fachmann versteht sofort, wie die Behandlungskammer 1 zu modifizieren ist, damit auch vier oder gar mehr verschiedene Behandlungsmedien getrennt gesammelt werden können.

Auch ist es möglich, wie bereits weiter oben erwähnt wurde, dass der Wafer 2 von beiden Seiten mit dem Behandlungsmedium 31, 32 beaufschlagt und beidseitig bearbeitet wird. Das ist gemäss Fig. 2a dadurch möglich, dass ein ringförmiger Rotor 61 verwendet wird, wobei zusätzlich zu der Zuführeinrichtung 7, die sich oberhalb des Wafers 2 befindet, eine weitere Zuführeinrichtung 70 auf der gegenüberliegenden Seite unter dem Wafer 2 angeordnet wird. Bevorzugt ist dabei zum Sammeln des von unten auf den Wafer 2 aufgetragenen Behandlungsmediums 31, 32 ein weiterer Sammelbehälter vorgesehen, der aus Gründen der Übersichtlichkeit in Fig. 2a nicht explizit dargestellt ist. Das heisst, bei Verwendung eines ringförmigen Rotors 61 ist es auch möglich, den vom ringförmigen Rotor 61 getragenen Körper 2, im speziellen Wafer 2 zur Herstellung mikroelektronischer Bauteile, nacheinander oder gleichzeitig von beiden Seiten mit einem Behandlungsmedium 31, 32 zu beaufschlagen, wie es in Fig. 2a anhand eines speziellen, nicht erfindungsgemäßen Ausführungsbeispiels exemplarisch dargestellt ist.

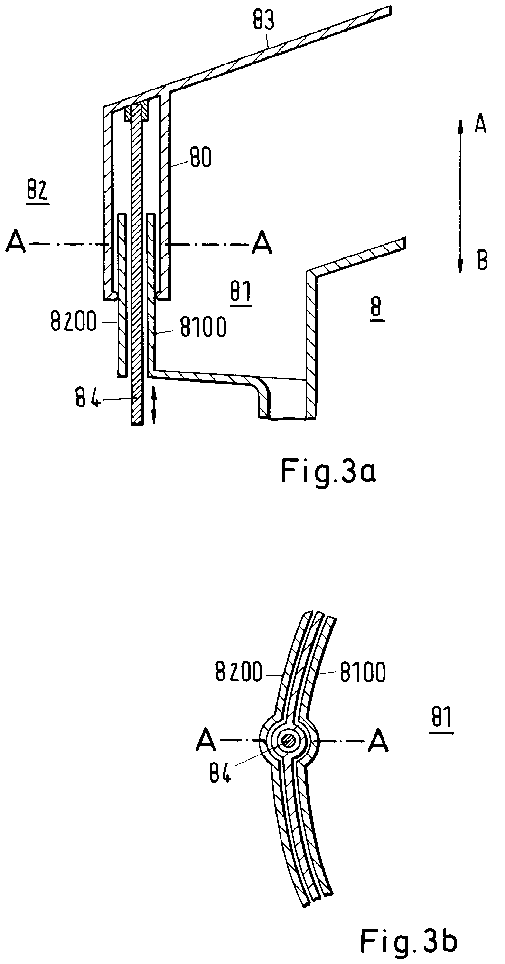

Die Verschiebung des Trennelements 80 zwischen der Position A und der Position B kann dabei auf jede geeignete Art technisch realisiert sein. Anhand der Fig. 3a bzw. Fig. 3b sowie Fig. 4 und Fig. 5 sind lediglich einige mögliche technische Lösungen exemplarisch skizziert. Der Fachmann versteht sofort, dass auch andere gleich wirkende Lösungen möglich sind und von der vorliegenden Erfindung auch abgedeckt sind.

Im Beispiel der Fig. 3a bzw. Fig. 3b, die einen Schnitt gemäss Fig. 3a entlang der Schnittlinie A - A darstellt, ist ein Ausführungsbeispiel dargestellt, bei welchem das Trennelement 80 über eine Schubstange 84 zum Beispiel mittels eines nicht explizit dargestellten Linearmotors angetrieben wird. Die dargestellte Kammer 81 ist durch die fest stehende Kammerwand 8100 und die Kammer 82 ist durch die feststehende Kammerwand 8200 in darstellungsgemäss vertikaler Richtung begrenzt. Zwischen den Kammerwänden 8100 und 8200 ist die über den nicht dargestellten Linearmotor verschiebbare Schubstange 84 angeordnet, die mit dem Ablaufkegel 83 derart verbunden, dass das Trennelement 80 samt Ablaufkegel 83 mittels der Schubstange 84 zischen der Position A und der Position B verschiebbar ist.

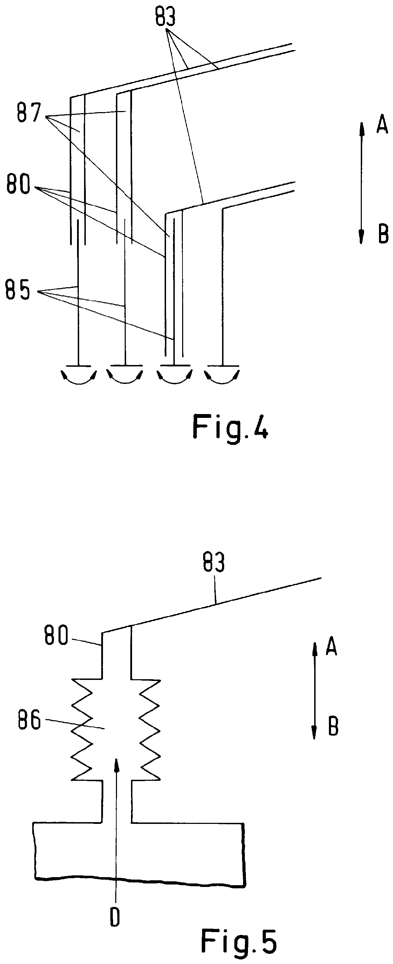

Anhand der Fig. 4 ist eine ähnliche Lösung dargestellt, bei welcher keine Schubstange 84 zur Verschiebung des Trennelements 80 vorgesehen ist, sondern eine Spindel 85 mit Aussengewinde, die mit einem Innengewinde zusammenwirkt, das in einer Bohrung 87 des Trennelements 80 vorgesehen ist. Die Spindel 85 ist dabei mit einem nicht explizit dargestellten Drehantrieb drehfest verbunden, so dass durch Drehen der Spindel 85 in eine der beiden Richtung das Trennelement 80 in die Position A geschoben werden kann und durch Drehung der Spindel 85 in die entgegen gesetzte Richtung in die Position B geschoben werden kann.

Auch besteht gemäss Fig. 5 das Trennelement 80 mittels eines Balg 86 zwischen der Position A und der Position B hin und her zu bewegen. Wir der Balg 86 mit einem Druck D, zum Beispiel mit Druckluft unter dem Druck B beaufschlagt, wir sich der elastische Balg 86 in an sich bekannter Weise verlängern und das Trennelement 80 mit Ablaufkegel 83 darstellungsgemäss nach oben in die Position A geschoben. Wir das Innere des Balgs vom Druck D wieder entlastet verkürzt sich der zuvor durch den Druck D elastisch gedehnte Balg wieder in seine Ruheposition zurück, wodurch das Trennelement 80 zurück in die Position B befördert wird.

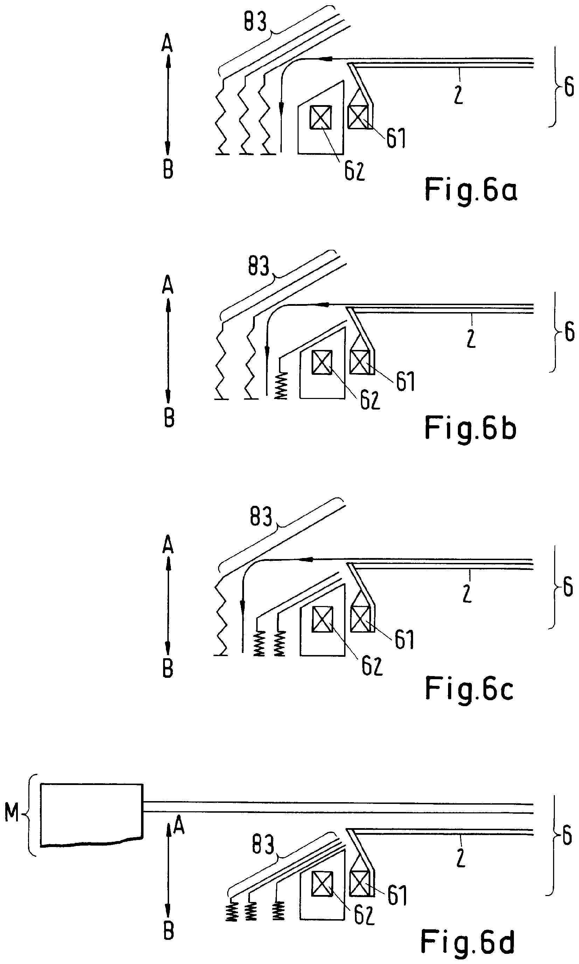

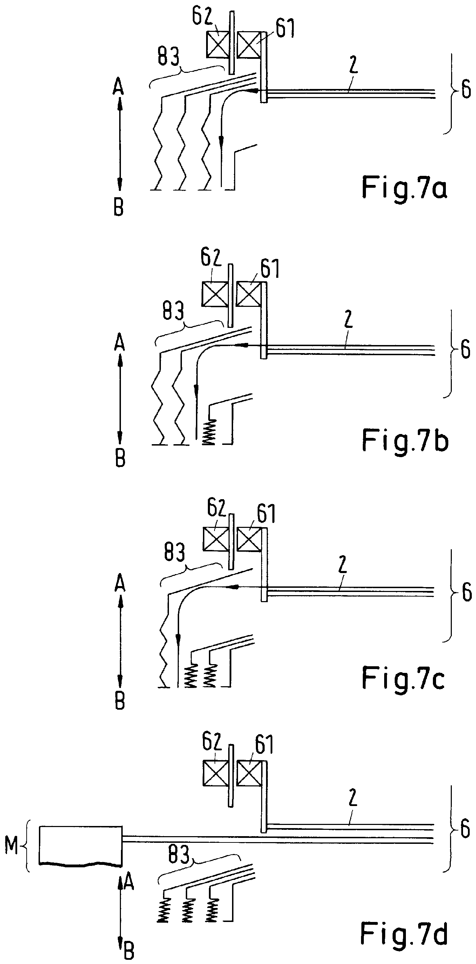

Zuletzt ist anhand der Fig. 6a bis 6d bzw. der Fig. 7a bis Fig. 7d noch je eine komplette Bearbeitungssequenz zur Bearbeitung eines Wafers 2 in einer nicht erfindungsgemässen Bearbeitungsvorrichtung 1 schematisch dargestellt.

Dabei unterscheidet sich die Bearbeitungssequenz der Fig. 6a bis Fig. 6b von denjenigen der Fig. 7a bis Fig. 7b lediglich dadurch, dass beim Ausführungsbeispiel der Fig. 6 eine Bearbeitungsvorrichtung verwendet wird, bei welcher der Wafer 2 liegend, also darstellungsgemäss über dem Rotor 61 angeordnet ist, während der Wafer 2 beim Beispiel der Fig. 7 hängend, also darstellungsgemäss unter dem Rotor angeordnet ist.

In einem ersten Bearbeitungsschritt (Fig. 6a bzw. 7a) wird der Wafer 2 zunächst mit einem ersten Bearbeitungsmedium behandelt, das in die darstellungsgemäss innere Kammer abgeleitet wird. Dazu sind alle Trennelemente 80 mit Ablaufkegel 83 in der Position A. Sodann wird gemäss Fig. 6b bzw. Fig. 7b das darstellungsgemäss innerste Trennelement 80 mit Ablaufkegel 83 in die Position B verschoben, so dass in einem zweiten Bearbeitungsschritt das zweite Bearbeitungsmedium in die mittlere Kammer geleitet wird.

Die Fig. 6c bzw. Fig. 7c zeigen schliesslich einen abschliessenden dritten Arbeitschritt, bei welchem der Wafer 2 mit einem dritten Bearbeitungsmedium, z.B. mit einem Lack beschichtet wird. Dazu sind die beiden innersten Trennelemente 80 in der unteren Position B, so dass das dritte Beschichtungsmedium in die darstellungsgemäss äusserste Kammer abgeleitet wird.

In Fig. 6d bzw. Fig. 7d sind alle Trennelemente 80 mit Ablaufkegel 83 in der unteren Position B. Das gestattet es einem Roboter M automatisch den fertig bearbeiteten Wafer 2 aus der jetzt (nicht dargestellten) geöffneten Prozesskammer herauszunehmen und die Prozesskammer für eine nächste vollständige Bearbeitungssequenz mit einem neuen Wafer 2 zu bestücken.

## Patentansprüche

1. Behandlungsvorrichtung zur Behandlung einer Oberfläche (21) eines Körpers (2) mit einem ersten Behandlungsmedium (31) und einem zweiten Behandlungsmedium (32), wobei die Behandlungsvorrichtung eine um eine Drehachse (4) rotierbare Halteeinrichtung (5) zur Aufnahme und Halterung des Körpers (2) umfasst, und ein mit der rotierbaren Halteeinrichtung (5) drehfest gekoppelter Drehantrieb (6, 61, 62), sowie eine Zuführeinrichtung (7) zur Zuführung des ersten Behandlungsmediums (31) und des zweiten Behandlungsmediums (32) auf die Oberfläche (21) des in der Halteeinrichtung (5) gehalterten Körpers (2) vorgesehen sind, wobei die Behandlungsvorrichtung einen Sammelbehälter (8) mit einem Trennelement (80) umfasst, welches Trennelement (80) den Sammelbehälter (8) derart in eine erste Kammer (81) und eine zweite Kammern (82) unterteilt, dass das erste Behandlungsmedium (31) in der ersten Kammer (81) und das zweite Behandlungsmedium (32) in der zweiten Kammer (82) getrennt sammelbar ist, wobei der Sammelbehälter (8) ein in Bezug auf die Halteeinrichtung (5) nicht verschiebbares Kammerbasisteil (800) umfasst, und das Trennelement (80) zwischen einer ersten Position (A) und einer zweiten Position (B) derart bewegbar angeordnet ist, dass in der ersten Position (A) das erste Behandlungsmedium (31) in die erste Kammer (81) ableitbar ist und in der zweiten Position (B) das zweite Behandlungsmedium (32) in die zweite Kammer (82) ableitbar ist, **dadurch gekennzeichnet, dass** der Drehantrieb (6, 61, 62) ein lagerloser Motor (6) ist, umfassend einen Stator (62) und einen bezüglich des Stators (62) berührungslos magnetisch gelagerten Rotor (61), wobei der lagerlose Motor (6) mit Rotor und Stator innerhalb der Prozesskammer ausgebildet ist.

2. Behandlungsvorrichtung nach Anspruch 1, wobei das nicht verschiebbare Kammerbasisteil (800) einen Kammerboden (801) umfasst, durch den das erste Behandlungsmedium (31) und das zweite Behandlungsmedium (32) aus dem Sammelbehälter (8) abführbar ist.

3. Behandlungsvorrichtung nach einem der vorangehenden Ansprüche, wobei das Trennelement (80) mittels einer Schubstange (84) zwischen der ersten Position (A) und einer zweiten Position (B) bewegbar ist.

4. Behandlungsvorrichtung nach einem der vorangehenden Ansprüche, wobei das Trennelement (80) mittels einer Spindel (85) zwischen der ersten Position (A) und einer zweiten Position (B) bewegbar ist.

5. Behandlungsvorrichtung nach einem der vorangehenden Ansprüche, wobei das Trennelement (80) mittels dehnbaren Balgs (86) zwischen der ersten Position (A) und einer zweiten Position (B) bewegbar ist.

6. Behandlungsvorrichtung nach einem der vorangehenden Ansprüche, wobei das Trennelement (80) in einem vorgebbaren Bereich aus einer flexiblen Wand gebildet ist.

7. Behandlungsvorrichtung nach einem der vorangehenden Ansprüche, wobei die rotierbare Halteeinrichtung (5) in einer Prozesskammer vorgesehen ist.

8. Behandlungsvorrichtung nach einem der vorangehenden Ansprüche, wobei der Drehantrieb (6, 61, 62) innerhalb der Prozesskammer vorgesehen ist.

9. Behandlungsvorrichtung nach einem der vorangehenden Ansprüche, wobei der Rotor (61) die Halteeinrichtung (5) bildet.

10. Behandlungsvorrichtung nach einem der vorangehenden Ansprüche, wobei der Rotor (61) als Ring (61) ausgebildet ist.

11. Behandlungsvorrichtung nach einem der vorangehenden Ansprüche, wobei der Rotor (61) permanent magnetisch ist.

12. Behandlungsvorrichtung nach einem der vorangehenden Ansprüche, wobei der Körper (2) eine Scheibe (2), insbesondere ein Wafer (2) zur Herstellung mikroelektronischer Bauelemente ist.

13. Behandlungsvorrichtung nach einem der vorangehenden Ansprüche, wobei zum automatischen Wechseln des Körpers (2) ein Manipulator (M), insbesondere eine Programm gesteuerte Robotereinheit (M) vorgesehen ist.

## Claims

1. A treatment apparatus for treating a surface (21) of a body (2) with a first treatment medium (31) and a second treatment medium (32), wherein the treatment apparatus includes a holding device (5) rotatable about an axis of rotation (4) for receiving and holding the body (2) and a rotary drive (6, 61, 62) rotationally fixedly coupled to the rotatable holding device (5) as well as a supply device (7) for supplying the first treatment medium (31) and the second treatment medium (32) to the surface (21) of the body held in the holding device (5) are provided, wherein the treatment apparatus includes a collection container (8) having a separation element (80), which separation element (80) divides the collection container (8) into a first chamber (81) and a second chamber (82) such that the first treatment medium (31) can be collected in the first chamber (81) and the second treatment medium (32) can be separately collected in the second chamber (82), wherein the collection container (8) includes a base chamber part (800) not displaceable with respect to the holding device (5) and the separation element (80) is movably arranged between a first position (A) and a second position (B) such that the first treatment medium (31) can be led off into the first chamber (81) in the first position (A) and the second treatment medium (32) can be led off into the second chamber (82) in the second position (B), **characterized in that** the rotary drive (6, 61, 62) is a bearingless motor (6) including a stator (62) and a rotor (61) contactlessly magnetically journalled with respect to the stator (62), wherein the bearingless motor (6) with rotor and stator is designed within the process chamber.

2. A treatment apparatus in accordance with claim 1, wherein the non-displaceable base chamber part (800) includes a chamber bottom (801) through which the first treatment medium (31) and the second treatment medium (32) can be led off from the collection container (8).

3. A treatment apparatus in accordance with one of the preceding claims, wherein the separation element (80) is movable by means of a connecting rod (84) between the first position (A) and a second position (B).

4. A treatment apparatus in accordance with any one of the preceding claims, wherein the separation element (80) is movable by means of a spindle (85) between the first position (A) and a second position (B).

5. A treatment apparatus in accordance with any one of the preceding claims, wherein the separation element (80) is movable by means of a stretchable bellows (86) between the first position (A) and a second position (B).

6. A treatment apparatus in accordance with any one of the preceding claims, wherein the separation element (80) is formed in a presettable region of a flexible wall.

7. A treatment apparatus in accordance with any one of the preceding claims, wherein the rotatable holding device (5) is provided in a process chamber.

8. A treatment apparatus in accordance with any one of the preceding claims, wherein the rotary drive (6, 61, 62) is provided within the process chamber.

9. A treatment apparatus in accordance with any one of the preceding claims, wherein the rotor (61) forms the holding device (5).

10. A treatment apparatus in accordance with any one of the preceding claims, wherein the rotor (61) is made as a ring (61).

11. A treatment apparatus in accordance with any one of the preceding claims, wherein the rotor (61) is permanently magnetic.

12. A treatment apparatus in accordance with any one of the preceding claims, wherein the body (2) is a disk (2), in particular a wafer (2), for manufacturing microelectronic components.

13. A treatment apparatus in accordance with any one of the preceding claims, wherein a manipulator (M), in particular a program-controlled robot unit (M), is provided for the automatic changing of the body (2).

## Revendications

1. Un dispositif de traitement pour traiter une surface (21) d'un corps (2) avec un premier milieu de traitement (31) et un deuxième milieu de traitement (32), dans lequel le dispositif de traitement comprend un dispositif de maintien (5) rotatif autour d'un axe de rotation (4) pour recevoir et maintenir le corps (2), et un entraînement rotatif (6, 61, 62) couplé de façon fixe en rotation au dispositif de maintien (5) rotatif ainsi qu'un dispositif d'alimentation (7) pour alimenter le premier milieu de traitement (31) et le deuxième milieu de traitement (32) sur la surface (21) du corps (2) maintenu dans le dispositif de maintien (5) sont prévus, dans lequel le dispositif de traitement comprend un récipient de collecte (8) ayant un élément de séparation (80), ledit l'élément de séparation (80) divise le récipient de collecte (8) en une première chambre (81) et une deuxième chambre (82) de sorte que le premier milieu de traitement (31) peut être collecté dans la première chambre (81) et le deuxième milieu de traitement (32) peut être collecté séparément dans la deuxième chambre (82), dans lequel le récipient de collecte (8) comprend une partie de base de la chambre (800) non déplaçable par rapport au dispositif de maintien (5) et l'élément de séparation (80) est disposé de manière mobile entre une première position (A) et une deuxième position (B) de telle sorte que le premier milieu de traitement (31) peut être déchargé dans la première chambre (81) dans la première position (A) et le deuxième milieu de traitement (32) peut être déchargé dans la deuxième chambre (82) dans la deuxième position (B), **caractérisé en ce que** l'entraînement rotatif (6, 61, 62) est un moteur sans palier (6) comprenant un stator (62) et un rotor (61) monté sans contact magnétiquement par rapport au stator (62), dans lequel le moteur sans palier (6) avec rotor et stator est conçu à l'intérieur de la chambre de traitement.

2. Un dispositif de traitement selon la revendication 1, dans lequel la partie de base de la chambre (800) non déplaçable comprend un fond de chambre (801) à travers lequel le premier milieu de traitement (31) et le deuxième milieu de traitement (32) peuvent être déchargés du récipient de collecte (8).

3. Un dispositif de traitement selon l'une des revendications précédentes, dans lequel l'élément de séparation (80) est mobile au moyen d'un poussoir (84) entre la première position (A) et une deuxième position (B).

4. Un dispositif de traitement selon l'une des revendications précédentes, dans lequel l'élément de séparation (80) est mobile au moyen d'une broche (85) entre la première position (A) et une deuxième position (B).

5. Un dispositif de traitement selon l'une des revendications précédentes, dans lequel l'élément de séparation (80) est mobile au moyen d'un soufflet expansible (86) entre la première position (A) et une deuxième position (B).

6. Un dispositif de traitement selon l'une des revendications précédentes, dans lequel l'élément de séparation (80) est formé dans une région prédéterminable à partir d'une paroi flexible.

7. Un dispositif de traitement selon l'une des revendications précédentes, dans lequel le dispositif de maintien (5) rotatif est prévu dans une chambre de traitement.

8. Un dispositif de traitement selon l'une des revendications précédentes, dans lequel l'entraînement rotatif (6, 61, 62) est prévu à l'intérieur de la chambre de traitement.

9. Un dispositif de traitement selon l'une des revendications précédentes, dans lequel le rotor (61) forme le dispositif de maintien (5).

10. Un dispositif de traitement selon l'une des revendications précédentes, dans lequel le rotor (61) est réalisé sous la forme d'un anneau (61).

11. Un dispositif de traitement selon l'une des revendications précédentes, dans lequel le rotor (61) est magnétique en permanence.

12. Un dispositif de traitement selon l'une des revendications précédentes, dans lequel le corps (2) est un disque (2), en particulier un wafer (2), pour la fabrication de composants microélectroniques.

13. Un dispositif de traitement selon l'une des revendications précédentes, dans lequel un manipulateur (M), en particulier une unité de robot (M) commandée par programme, est prévu pour le changement automatique du corps (2).
